# EUROPEAN PATENT SPECIFICATION

(11) **EP 4 645 178 B1**
(45) Date of publication and mention of the grant of the patent: **25.03.2026**
(21) Application number: 24174099.2
(22) Date of filing: 03.05.2024
(51) Int. Cl.: G06N 10/40, H01L 21/48, H01L 23/14, H01L 23/15, H01L 23/498, G21K 1/00

(54) **ION TRAP MANUFACTURING METHODS**
IONENFALLENHERSTELLUNGSVERFAHREN
PROCÉDÉS DE FABRICATION DE PIÈGE À IONS

(43) Date of publication of application: 05.11.2025
(73) Proprietor: Infineon Technologies Austria AG, 9500 Villach (AT)
(72) Inventor: GLANTSCHNIG, Max, 9500 Villach (AT); FLASCH, Christian, 5310 Mondsee (AT); AUCHTER, Silke Katharina, 9500 Villach (AT); ZESAR, Alexander, 9500 Villach (AT)
(74) Representative: Infineon Patent Department

(56) References cited:
- WO-A1-2023/205218
- US-A1- 2022 367 164
- US-A1- 2023 019 665
- US-A1- 2023 043 673
- BRITTON J ET AL: "A microfabricated surface-electrode ion trap in silicon", ARXIV.ORG, CORNELL UNIVERSITY LIBRARY, 201 OLIN LIBRARY CORNELL UNIVERSITY ITHACA, NY 14853, 19 May 2006 (2006-05-19), XP080239532

## Description

### Technical Field

The present invention relates to methods for manufacturing an electrical via connection through a dielectric substrate of an ion trap device.

### Background

Due to an upscaling of ion traps towards useful quantum computing and an optimization of ion traps for precision metrology, the demands on the structural complexity of ion traps are increasing. To meet the demands of new generations of ion traps, new fabrication processes need to be developed for enabling reliable and scalable microfabrication of complex technical features. One such complex feature that may be useful for future ion traps is known as through-substrate structuring. In this process, parts of the substrate may be removed, thereby generating holes that may extend through the entire substrate. The holes may be used in ion traps in a variety of applications, such as through-substrate electrical vias, ion loading slots or as optical access points. In general, the development of ion trap devices may aim at a straightforward and easy scaling of the devices in order to increase the number of trapped ions. In view of the above, it may be desirable to provide ion trap
manufacturing methods providing an improved through-substrate structuring.

US 2022/367164 A1 discloses that in an ion trap chip, an RF electrode for producing a radiofrequency ion-trapping electric field is formed in one of a plurality of metallization layers formed on a substrate and separated from each other by intermetal dielectric. At least two spans of the RF electrode are suspended between support pillars over a void defined within one or more layers of intermetal dielectric. For each span that is suspended between a first and a second support pillar, two areas are defined. A first area is the total electrode area from an initial edge of the first support pillar to an initial edge of the second support pillar. A second area is the electrode area directly underlain by the first support pillar. In each span that is suspended from a first support pillar to a second support pillar, The second area is not more than one-half of first area.

US 2023/043673 A1 discloses that a cryo-compatible quantum computing arrangement includes a microelectronic quantum computing component having a substrate structure, a plurality of first contact elements and a plurality of conductive feedthroughs through the substrate structure. The conductive feedthroughs are electrically connected on a first main surface area of the substrate structure to associated first contact elements of the microelectronic quantum computing component. A further microelectronic component has a plurality of second contact elements. On a second main surface area of the substrate structure, the conductive feedthroughs are electrically connected to associated second contact elements of the further microelectronic component. The conductive feedthroughs each include, between the first and second contact elements, a layer element including a first material that is superconducting at a quantum computing operating temperature, and a filling element including a second material that is electrically conductive.

It is therefore an object of the present invention to provide an improved method for manufacturing an electrical via connection through a dielectric substrate of an ion trap device.

This object is solved by the subject matter of claim 1.

An aspect of the present invention relates to a method for manufacturing an electrical via connection through a dielectric substrate of an ion trap device. The method comprises an act of forming an electrically conductive etch stop layer on a first main surface of the dielectric substrate. The method further comprises an act of forming at least one metal layer of an ion trap over the etch stop layer. The method further comprises an act of etching a via hole into a second main surface of the dielectric substrate opposing the first main surface and through the dielectric substrate, such that the etch stop layer is exposed. The method further comprises an act of disposing an electrically conductive material in the via hole, wherein the etch stop layer electrically couples the electrically conductive material and the metal layer.

### Brief Description of the Drawings

Methods in accordance with the invention are described in more detail below based on the drawings. Similar reference numerals may designate corresponding similar parts. The technical features of the various illustrated examples may be combined unless they exclude each other and/or can be selectively omitted if not described to be necessarily required.
Figure 1 illustrates a flowchart of a method in accordance with the invention .
Figure 2 includes Figures 2A to 2I schematically illustrating a cross-sectional side view of a method in accordance with the invention. Figure 2I illustrates an ion trap device 200
Figure 3 includes Figures 3A to 3J schematically illustrating a cross-sectional side view of a method in accordance with the invention. Figure 3J illustrates an ion trap device 300

### Detailed Description

The following description relates to devices for controlling trapped ions (ion trap devices) and methods for manufacturing an electrical via connection through a dielectric substrate of an ion trap device. The ion trap devices described herein may be configured to trap ions and control the trapped ions. It is to be noted that the following description is not restricted to ions, but may also be applied to atoms, molecules or other quantum particles/systems (e.g. electrons or defect centers).

In some examples, the ion trap devices described herein may be used for quantum computing, but are not restricted thereto. Trapped ions are one of the most promising candidates for being used as qubits in quantum computers, since they can be trapped with rather long lifetimes by means of electromagnetic fields. In this context, each ion may represent a physical qubit. However, ion trap devices are not restricted to the application of quantum computing. The ion trap devices presented herein may also be used for other applications, such as e.g. atomic clocks.

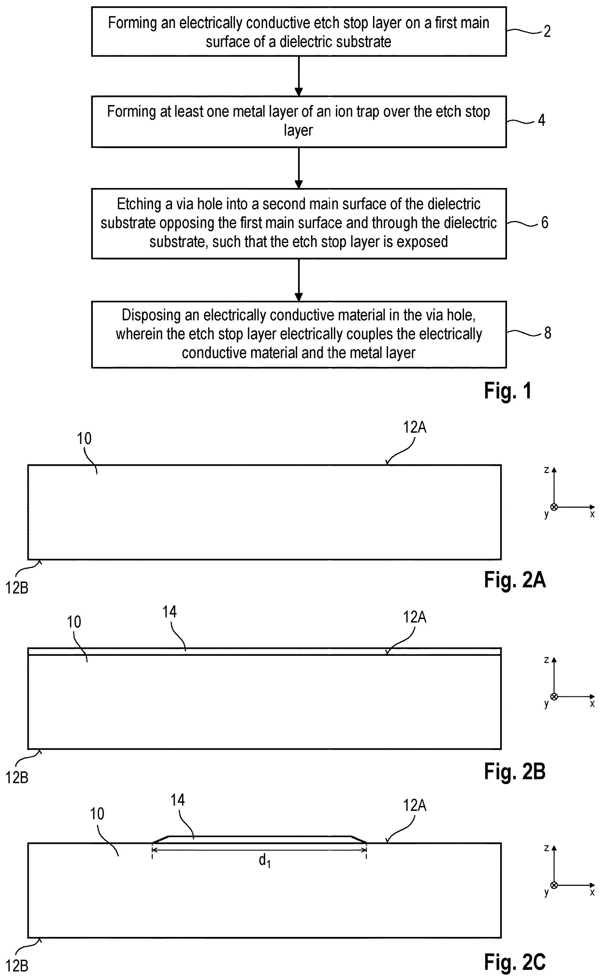

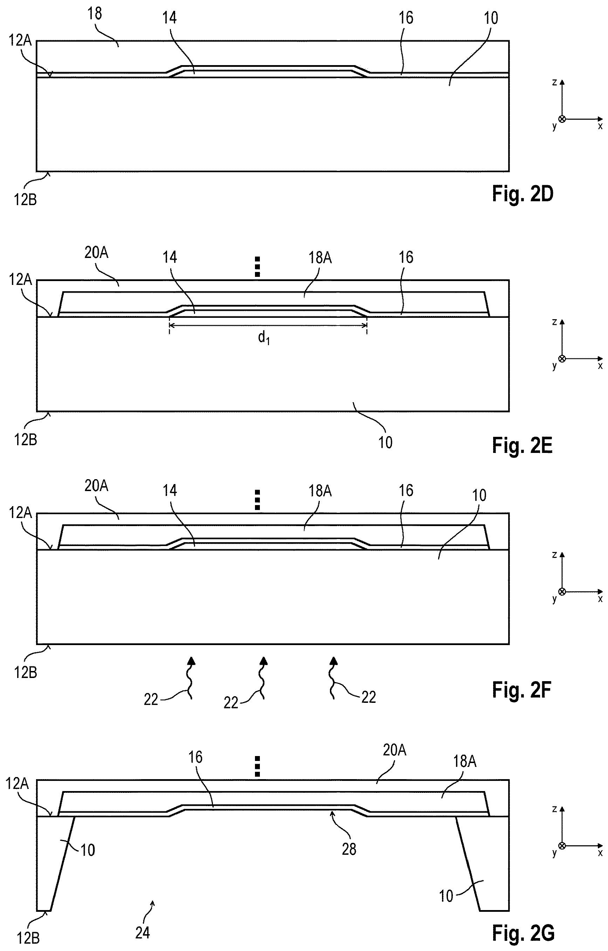

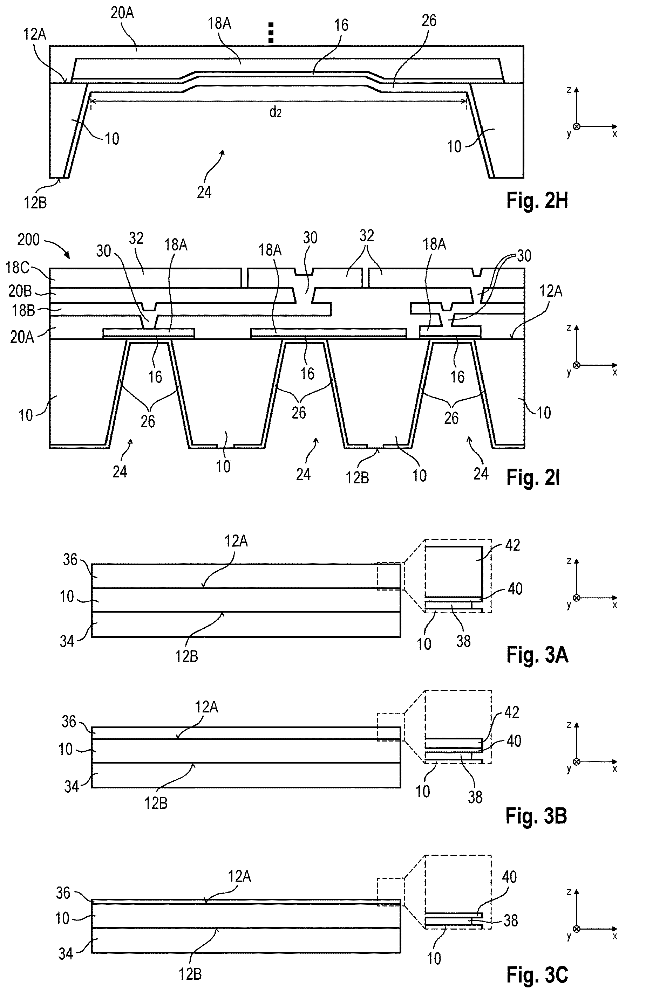

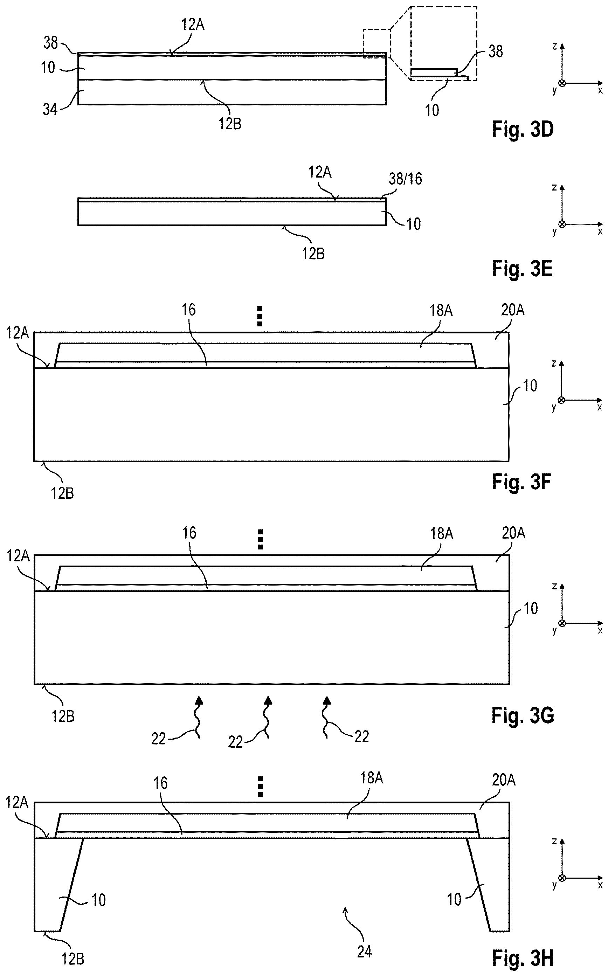

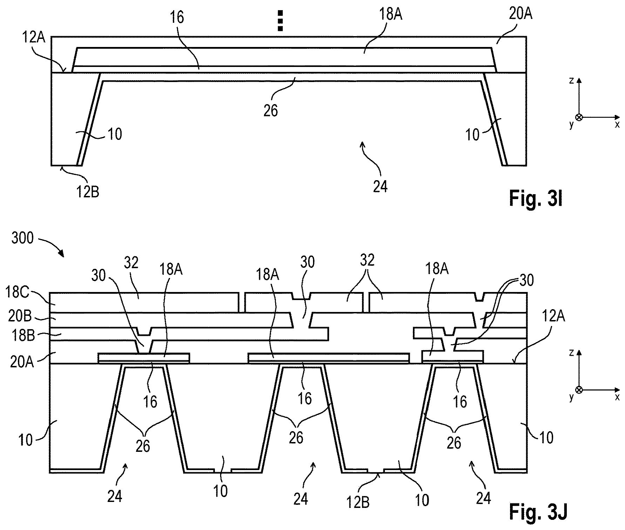

Referring now to Figure 1, a flowchart of a method in accordance with the invention is illustrated. The method is described in a general manner in order to qualitatively specify aspects of the invention The method is used for manufacturing an electrical via connection through a dielectric substrate of an ion trap device. In addition, the method is used in the fabrication of an ion trap device in accordance with the invention. It is to be understood that the method may include further aspects. For example, the method may be extended by any of the aspects described in connection with the methods of Figures 2 and 3.

In an act 2, an electrically conductive etch stop layer is formed on a first main surface of the dielectric substrate. In an act 4, at least one metal layer of an ion trap is formed over the etch stop layer. In an act 6, a via hole is etched into a second main surface of the dielectric substrate opposing the first main surface and through the dielectric substrate, such that the etch stop layer is exposed. In an act 8, an electrically conductive material is disposed in the via hole. The etch stop layer electrically couples the electrically conductive material and the metal layer.

Referring now to Figures 2A to 2I, a further method in accordance with the invention is described. The method may be seen, at least in parts, as a more detailed version of the method of Figure 1. Similar to Figure 1, the method of Figure 2 is used for manufacturing an electrical via connection through a dielectric substrate of an ion trap device. An ion trap device 200 manufactured by the method is shown in Figure 2I.

In Figure 2A, a dielectric substrate 10 having a first main surface 12A and an opposing second main surface 12B is provided. For example, the dielectric substrate 10 may include or may be made of at least one of glass or sapphire. In the illustrated example, the dielectric substrate 10 may particularly include or may be made of fused silica glass.

In Figure 2B, a sacrificial layer 14 may be formed on the first main surface 12A of the dielectric substrate 10. For example, the sacrificial layer 14 may include or may be made of aluminum. The sacrificial layer 14 may be formed based on any suitable technique, such as e.g. sputter deposition. A thickness of the sacrificial layer 14 may be in a range from about 200nm to about 1000nm, more particular from about 200nm to about 400nm, when measured in the z-direction. In one specific but non-limiting case, the sacrificial layer 14 may have a thickness of about 300nm. In particular, the sacrificial layer 14 may be homogeneously formed on the first main surface 12A with a substantially constant thickness.

In Figure 2C, the sacrificial layer 14 may be structured. In this context, the sacrificial layer 14 may be partially removed using any suitable technique, such as e.g. a wet chemical structuring process. After partially removing the sacrificial layer 14, one or more portions of the sacrificial layer 14 may remain at selected locations on the first main surface 12A. In the illustrated example, only a single portion of the sacrificial layer 14 is shown for the sake of simplicity. However, it is to be understood that the structured sacrificial layer 14 may include an arbitrary number of remaining portions. The remaining portion of the sacrificial layer 14 may be aligned with a region where a via hole is to be etched in the dielectric substrate 10 later on. For example, when measured in the x-direction, a diameter (or width) *d₁* of a remaining portion may be greater than about 10um and smaller than a diameter of the via hole that is to be manufactured. In examples, the remaining portion of the sacrificial layer 14 may have a sidewall that is tapered such that angle of the sidewall with respect to the first main surface 12A is smaller than about 90°, for example smaller than about 70°. The remaining portion of the sacrificial layer 14 may have a rounding at the position where the sidewall meets the top surface of the remaining portion.

In a further act of Figure 2C, a material layer (not illustrated) may be formed on the structured sacrificial layer 14. For example, the material layer may include at least one of TEOS, silicon nitride, aluminum oxide, silicon oxide, aluminum nitride. The material layer may be configured to further lower the sidewall taper of the portions of the structured sacrificial layer 14 as previously described and to further smooth their edges.

In Figure 2D, an electrically conductive etch stop layer 16 is formed on the first main surface 12A of the dielectric substrate 10 and may be formed on the structured sacrificial layer 14. For example, the act of Figure 2D may correspond to the act 2 of Figure 1. The etch stop layer 16 may also be referred to as barrier layer or etch stop barrier layer. In the illustrated example, the etch stop layer 16 may include or may be made of titanium nitride. The etch stop layer 16 may be formed based on any suitable technique, such as e.g. sputter deposition. For example, a thickness of the etch stop layer 16 may be in a range from about 50nm to about 150nm (or may be even higher in some examples) when measured in the z-direction. In one specific but non-limiting case, the etch stop layer 16 may have a thickness of about 100nm. In particular, the etch stop layer 16 may be homogeneously formed on the first main surface 12A and the structured sacrificial layer 14 with a substantially constant thickness. A homogenous and constant thickness of the etch stop layer 16 may be supported by the flat sidewall angle of the structured sacrificial layer 14. The smooth edges of the structured sacrificial layer 14 may mitigate the risk of seam line defects.

In a further act of Figure 2D, a first metal layer 18A is formed on the etch stop layer 16. For example, this act may correspond to the act 4 of Figure 1. The first metal layer 18A may include or may be made of at least one of aluminum, copper, or alloys thereof. The first metal layer 18A may be formed based on any suitable technique, such as e.g. sputter deposition. A thickness of the first metal layer 18A may be in a range from about 500nm to about 2µm (and in some cases even greater than 2µm) when measured in the z-direction. The first metal layer 18A may be at least partially structured. A functionality of the first metal layer 18A as a part of an ion trap will be described later on in connection with Figure 2I.

In Figure 2E, a first dielectric layer 20A may be formed on the metal layer 18A. For example, the first dielectric layer 20A may include or may be made of at least one of an oxide or a nitride. A thickness of the first dielectric layer 20A may be in a range from about 1.5um to about 2.5µm (or may be even smaller in some examples, such as down to about 300nm) when measured in the z-direction. In one specific but non-limiting case, the first dielectric layer 20A may have a thickness of about 2um. In the illustrated example, only a single metal layer 18A and a single dielectric layer 20A are shown. However, in further acts, additional metal layers and dielectric layers may be formed which is indicated in Figure 2E by dots over the first dielectric layer 20A. The first dielectric layer 20A may be configured to electrically isolate the first metal layer 18A from further metal layers disposed thereon.

In Figure 2F, the dielectric substrate 10 may be laser-modified in a region where a via hole is to be etched in the dielectric substrate 10. In this context, laser radiation (or laser pulses) 22 may be focused into the dielectric substrate 10, wherein the region of the dielectric material 10 interacting with the laser radiation 22 may show an increased selectivity with regard to a subsequent etching process. Stated differently, an etch rate of the dielectric substrate 10 may be increased in the laser-modified region. For example, a laser treatment and subsequent etching may be based on at least one of a laser induced deep etching (LIDE) technique or a selective laser induced etching (SLE) technique.

As previously discussed, the remaining portion of the sacrificial layer 14 may be aligned with the via hole that is to be etched and thus also with the laser-modified region. During laser modification, the sacrificial layer 14 may serve as a buffer for reflecting laser irradiation and may further be configured to absorb laser generated energy in order to protect the etch stop layer 16 from damage. In other words, the sacrificial layer 14 may ensure that the etch stop layer 16 is not damaged by the laser. In addition, the etch stop layer 16 itself may be configured and designed to at least partially resist damage by the laser.

In Figure 2G, a via hole 24 is etched into the second main surface 12B of the dielectric substrate 10. For example, the act of Figure 2G may correspond to the act 6 of Figure 1. In particular, the via hole 24 may be generated by selectively etching the laser-modified region of the dielectric substrate 10. For example, the etching process may include or may correspond to a wet etching process, wherein the etchant may be chosen according to the material of the dielectric substrate 10. In specific cases, the etchant may include or may be based on at least one of a pad etch solution, hydrofluoric acid, or the like. The etching process is performed until the etch stop layer 16 is exposed and may stop on the etch stop barrier 16. The sacrificial layer 14 may be (in particular fully) removed during etching the via hole 24, such that a recess 28 aligned with the via hole 24 may be formed in the etch stop layer 16.

In order to generate a reliably etched via hole 24 extending through the dielectric substrate 10, the dielectric substrate 10 may need to be etched until the final via diameter measured in the x-direction is reached. The duration of the etching may depend on the substrate type, substrate thickness, chemistry used and the selectivity of the chemistry to the specific laser process used. In non-limiting examples, the dielectric substrate 10 may need to be etched over a time interval of e.g. at least about 60 minutes. More specific, an etching process may last from about 60 minutes to about 120 minutes. Accordingly, the etch stop layer 16 may be configured to withstand direct etchant exposure for the duration of the etch time interval. In the exemplary cross-sectional side view of Figure 2G, the manufactured via hole 24 may have a conical shape which may particularly result from a used etching technique. When viewed in the z-direction, the via hole 24 may e.g. have a circular shape. However, other shapes of the manufactured via hole 24 may be contemplated

In Figure 2H, an electrically conductive material 26 is disposed in the via hole 24. For example, the act of Figure 2H may correspond to the act 8 of Figure 1. In the illustrated example, an electrically conductive layer 26 may be formed on an inner surface of the via hole 24 and on the exposed etch stop layer 16. The electrically conductive layer 26 may include or may be made of a metal, such as e.g. at least one of titanium or copper. In the illustrated example, the electrically conductive layer 26 may consist of a single metal layer. In further examples, the electrically conductive layer 26 may be formed by a stack of conductive layers. A thickness of the electrically conductive layer 26 may be in a range from about 500nm to about 1.5um. In one specific but non-limiting case, the electrically conductive layer 26 may have a thickness of about 1µm. In the exemplary cross-sectional side view of Figure 2H, a diameter (or width) *d₂* of the metallized via hole 24 may be in a range from about 60um to about 100um when measured in the x-direction.

After a deposition of the electrically conductive material 26, the etch stop layer 16 electrically couples the electrically conductive material 26 and the first metal layer 18A. In one example, the etch stop layer 16 may be in direct mechanical and electrical contact with the electrically conductive material 26 and the first metal layer 18A. In further examples, one or more additional conductive layers may be arranged between the etch stop layer 16 and the first metal layer 18A. In addition to its function as an etch stop, the etch stop layer 16 is therefore also configured to provide a suitable electrical connection between the electrically conductive material 26 and the first metal layer 18A. The metallized via hole 24 forms an electrical via connection extending through the dielectric substrate 10. For the case of a glass substrate 10, the metallized via hole 24 may correspond to a through glass via (TGV) connection.

Figure 2I illustrates an ion trap device 200 which may have been manufactured by the previously described acts of Figure 2. That is, the ion trap device 200 may include some or all features discussed in connection with Figures 2A to 2H. For the sake of simplicity, in preceding figures the formation of a single via hole 24 in the dielectric substrate 10 was shown. However, it is to be understood that ion trap devices may include a plurality of such via holes 24. A specific number and location of the via holes 24 may depend on the design and the type of the ion trap device that is to be manufactured.

The ion trap device 200 of Figure 2I may include the dielectric substrate 10 and at least one via hole 24 extending through the dielectric substrate 10 from the first main surface 12A of the dielectric substrate 10 to the second main surface 12B of the dielectric substrate 10. The electrically conductive etch stop layer 16 may be arranged on the first main surface 12A of the dielectric substrate 10 and may cover the via hole(s) 24. A first metal layer 18A may be arranged on the etch stop layer 16. Furthermore, an electrically conductive material 26 may be arranged in the via hole 26. The etch stop layer 16 may electrically couple the electrically conductive material 26 and the first metal layer 18A.

The etch stop layer 16 may be structured and/or aligned with the via hole(s) 24. In the illustrated example, the etch stop layer 16 may include multiple portions, wherein each portion may cover one of the via holes 24. The electrically conductive material 26 may include an electrically conductive layer formed on an inner surface of the via hole 24 and on the bottom surface of the etch stop layer 16 covering the via hole 24. In particular, the etch stop layer 16 may be in direct contact with the top surface of the electrically conductive material 26 and the bottom surface of the first metal layer 18A. In some examples, the electrically conductive material 26 may also be at least partially arranged on the second main surface 12B of the dielectric substrate 10.

The first metal layer 18A may be segmented and/or may particularly be aligned with the portions of the etch stop layer 16. The ion trap device 200 may include a plurality of additional metal layers and dielectric layers arranged over the first metal layer 18A and the first dielectric layer 20A that may have been formed in further acts of the method of Figure 2. In the illustrated example, an additional second metal layer 18B and third metal layer 18C as well as one additional second dielectric layer 20B are shown. The metal layers 18B and 18C may be similar to the first metal layer 18A, and/or the second dielectric layer 20B may be similar to the first dielectric layer 20A as previously described. It is to be understood that the number of metal layers and dielectric layers may differ in further examples. The ion trap device 200 may further include a plurality of electrically conductive via connections 30 which may extend through the dielectric layers, in particular in the z-direction. The via connections 30 may be configured to electrically connect metal layers arranged on different levels with respect to the z-direction.

The third metal layer 18C may include or may correspond to a structured electrode layer forming multiple electrodes 32 of the ion trap device 200. In the illustrated example, the electrodes 32 may consist of a single metal layer. In further examples, at least one of the electrodes 32 may be formed by a stack of conductive layers, such as e.g. Al/Ti/Pt/Au. The electrodes 32 may be configured to trap ions in a zone above the structured electrode layer 18C as will be described below.

The second metal layer 18B arranged between the first metal layer 18A and the structured electrode layer 18C may include or may correspond to an electrical redistribution layer. The electrical redistribution layer 18B may be configured to electrically couple the first metal layer 18A and the electrodes 32 and to provide an electrical redistribution between them. In the shown case, the electrical redistribution layer 18B may exemplarily consist of a single metal layer. In further examples, the electrical redistribution layer 18B may include multiple metal layers that may be arranged on different levels with respect to the z-direction.

Ions trapped in or by the ion trap device 200 may be shuttled (or transported) along shuttling paths of the device. For example, the shuttling paths may extend above the structured electrode layer 18C including the electrodes 32. In particular, a shuttling path may be arranged in a plane over the structured electrode layer 18C. Time-dependent electric fields may be used for shuttling ions along the shuttling paths. A shuttling of ions may be controlled by electric voltages applied to the electrodes 32 of the structured electrode layer 18C. In this context, the ion trap device 200 may further include at least one unit (not illustrated) configured to control the electric voltages applied to the electrodes 32, such as e.g. a control chip. In this context, the electrodes 32 may be electrically accessible via the electrically conductive layer 26, the electrically conductive etch stop layer 16, the first metal layer 18A, the electrical redistribution layer 18B and the via connections 30 arranged in between.

In some examples, the ions may be moved along shuttling paths by means of AC and DC voltages that may be separately coupled to specific electrodes 32 of the structured electrode layer 18C. For example, the structured electrode layer 18C may include RF electrodes for RF trapping and DC electrodes for static electric-field trapping and/or for moving the ions within the ion trap. As another example, ions may be confined by the combination of an external magnetic field and electrostatic quadrupole fields generated by voltages applied to DC electrodes. Ion trap devices as described herein may be configured to trap a plurality of ions that may be individually addressable and movable by appropriately controlling the electric potentials of the electrodes 32.

In one specific but non-limiting example, ion trap devices as described herein may correspond to or may include a surface ion trap (or surface-electrode ion trap). In surface ion traps, all electrodes 32 (i.e. the DC electrodes and the RF electrodes) may be arranged in a same single plane. The ions may be stored and shuttled above this single plane. However, it is to be understood that the concepts described herein are not restricted to surface ion traps. In further examples, devices for controlling trapped ions may also be based on three-dimensional ion trap geometries (e.g., where two or more trapping planes are arranged on top of each other).

Referring now to Figures 3A to 3J, a further method in accordance with the invention is described. The method of Figure 3 may be seen, at least in parts, as a more detailed version of the method of Figure 1. Similar to previous examples, the method of Figure 3 is used for manufacturing an electrical via connection through a dielectric substrate of an ion trap device. An ion trap device 300 manufactured by the method is shown in Figure 3J.

At first, in Figures 3A to 3E, an etch stop layer is formed on a first main surface of a dielectric substrate. Referring back to the example of Figure 1, the act 2 of Figure 1 may include some or all of the technical features described in connection with Figures 3A to 3E.

In Figure 3A, an arrangement including a carrier 34, a dielectric substrate 10 arranged on the carrier 34 and a silicon-on-insulator (SOI) wafer 36 arranged on the dielectric substrate 10 may be provided. As shown in an enlarged detail on the right of Figure 3A, the SOI wafer 36 may include a degenerately doped crystalline (in particular single crystalline) silicon layer 38 facing a first main surface 12A of the dielectric substrate 10, a buried oxide layer 40 arranged on the crystalline silicon layer 38 and a silicon layer 42 (or bulk silicon layer) arranged on the buried oxide layer 40.

The carrier 34 may include or may be made of any suitable material, such as e.g. silicon. In the illustrated example, the carrier 34 may be a silicon wafer which may have been grinded from its bottom surface to a desired target thickness. For example, a thickness of the carrier 34 may be in a range from about 250µm to about 400um when measured in the z-direction. In one specific but non-limiting example, the carrier 34 may have a thickness of about 325µm.

The dielectric substrate 10 may include or may be made of at least one of glass or sapphire. In the illustrated example, the dielectric substrate 10 may particularly include or may be made of borosilicate glass. For example, a thickness of the dielectric substrate 10 may be in a range from about 300um to about 500um when measured in the z-direction. In one specific but non-limiting example, the dielectric substrate 10 may have a thickness of about 400um.

The crystalline silicon layer 38 may be n-doped or p-doped. In some examples, the crystalline silicon layer 38 may be doped with at least one of phosphorus or boron. In particular, the crystalline silicon layer 38 may be so heavily doped that it may at least partially act like a metal. In other words, the crystalline silicon layer 38 may be electrically conductive. As will become apparent later on, the degenerately doped crystalline silicon layer 38 may be used as an electrically conductive etch stop layer (such as the one formed in act 4 referenced above with regard to Figure 1). For example, a thickness of the crystalline silicon layer 38 may be in a range from about 500nm to about 1.5µm when measured in the z-direction. In one specific but non-limiting example, the crystalline silicon layer 38 may have a thickness of about 1µm. In particular, a thickness of the crystalline silicon layer 38 may be chosen thick enough such that damage of a laser process performed later on does not fully destroy the layer.

The buried oxide layer 40 may be arranged between the crystalline silicon layer 38 and the silicon layer 42. It is noted that both the silicon above as well as the silicon below the buried oxide layer 40 may be crystalline (in particular single crystalline). For example, a thickness of the buried oxide layer 40 may be in a range from about 250nm to about 750nm when measured in the z-direction. In one specific but non-limiting example, the buried oxide layer 40 may have a thickness of about 500nm. A total thickness of the SOI wafer 36 may be in a range from about 300um to about 500um when measured in the z-direction. In one specific but non-limiting example, the SOI wafer 36 may have a total thickness of about 400um.

In Figure 3B, the silicon layer 42 may be at least partially removed. More particular, the SOI wafer 36 may be thinned from its top surface. In one example, the top surface of the silicon layer 42 may be grinded until the SOI wafer 36 has reached a residual thickness which may be in a range from about 10µm to about 20µm (e.g. approximately 15um) in one specific but non-limiting example.

In Figure 3C, further material of the silicon layer 42 may be removed. Again, the SOI wafer 36 may be further thinned from its top surface. In one example, the top surface of the SOI wafer 36 may be spin etched, wherein the top surface of the buried oxide layer 40 may be exposed. The spin etching process may stop on the top surface of the buried oxide layer 40. After performing the act of Figure 3C, the silicon layer 42 may be completed removed.

In Figure 3D, the buried oxide layer 40 may be removed. In one example, the top surface of the buried oxide layer 40 may be etched, wherein the top surface of the crystalline silicon layer 38 may be exposed. After performing the act of Figure 3D, the buried oxide layer 40 may be completely removed and the crystalline silicon layer 38 may remain on the top surface of the dielectric substrate 10. As will become apparent later on, the crystalline silicon layer 38 may act as an electrically conductive etch stop layer later on. In subsequent figures, the crystalline silicon layer 38 may therefore be referred to as etch stop layer and may be designated with reference numeral 16. It is to be noted that the crystalline silicon layer 38 may also be manufactured in a different way from the process described above in connection with Figures 3A to 3D. For example, a standard (not-highly doped) silicon wafer may be bonded on top of the dielectric substrate 10, thinning it down to about 1 µm, and then doping it by ion implantation.

In Figure 3E, the carrier 34 may be removed.

In Figures 3F to 3I, further acts of the method may be performed which may particularly include some or all features previously described in connection with Figures 2D to 2H. For reasons of brevity and conciseness, however, the detailed explanations given above will not be repeated here. In particular, in Figure 3F, a first metal layer 18A is, and a first dielectric layer 20A as well as additional metal layers and dielectric layer (see dots) may be, formed on the etch stop layer 16 as previously described in connection with Figures 2D and 2E. In Figure 3G, the dielectric substrate 10 may be laser-modified as previously described in connection with Figure 2F. In Figure 3H, a via hole 24 is etched in the dielectric substrate 10 as previously described in connection with Figure 2G. In Figure 3I, an electrically conductive material 26 is arranged in the via hole 24 as previously described in connection with Figure 2H.

Figure 3J illustrates an ion trap device 300 which may have been manufactured by the method of Figure 3. In particular, the ion trap device 300 may be at least partially similar to the ion trap device 200 of Figure 2I. While the ion trap device 200 of Figure 2I may particularly be based on a dielectric substrate 10 including fused silica glass and an etch stop layer 16 including titanium nitride, the ion trap device 300 of Figure 3I may particularly be based on a dielectric substrate 10 including borosilicate glass and an etch stop layer 16 including degenerately doped crystalline silicon.

As used in this specification, the terms "substantially", "approximately", "about", or the like, may mean "within reasonable tolerances for manufacturing". For example, the terms "substantially", "approximately", "about", or the like, may be used herein to account for small manufacturing tolerances or other factors (e.g., within 5%) that are deemed acceptable in the industry without departing from the aspects of the examples described herein. For example, a material layer with an approximate thickness value may practically have a thickness within 5% of the approximate thickness value.

As used herein, the terms "electrically connected" or "electrically coupled" or similar terms are not meant to mean that the elements are directly contacted together; intervening elements may be provided between the "electrically connected" or "electrically coupled" elements, respectively. However, in accordance with the disclosure, the above-mentioned and similar terms may, optionally, also have the specific meaning that the elements are directly contacted together, i.e. that no intervening elements are provided between the "electrically connected" or "electrically coupled" elements, respectively.

Further, the words "over" or "on" with regard to a part, element or material layer formed or located or arranged "over" or "on" a surface may be used herein to mean that the part, element or material layer be located (e.g. placed, formed, arranged, deposited, etc.) "directly over" or "directly on", e.g. in direct contact with, the implied surface. The word "over" or "on" used with regard to a part, element or material layer formed or located or arranged "over" or "on" a surface may, however, either be used herein to mean that the part, element or material layer be located (e.g. placed, formed, arranged, deposited, etc.) "indirectly over" or "indirectly on" the implied surface, with one or more additional parts, elements or layers being arranged between the implied surface and the part, element or material layer.

Nevertheless the extent of the invention shall be determined by the appended claims.

## Claims

1. A method for manufacturing an electrical via connection through a dielectric substrate (10) of an ion trap device, the method comprising:
forming an electrically conductive etch stop layer (16) on a first main surface (12A) of the dielectric substrate (10);
forming at least one metal layer (18A) of an ion trap over the etch stop layer (16);
etching a via hole (24) into a second main surface (12B) of the dielectric substrate (10) opposing the first main surface (12A) and through the dielectric substrate (10), such that the etch stop layer (16) is exposed; and
disposing an electrically conductive material (26) in the via hole (24), wherein the etch stop layer (16) electrically couples the electrically conductive material (26) and the metal layer (18A).

2. The method of claim 1, wherein disposing the electrically conductive material (26) in the via hole (24) comprises forming an electrically conductive layer on an inner surface of the via hole (24) and on the exposed etch stop layer (16).

3. The method of claim 1 or 2, further comprising:
before etching the via hole (24), laser-modifying the dielectric substrate (10) in a region where the via hole (24) is to be etched, thereby increasing an etch rate of the dielectric substrate (10) in the laser-modified region; and/or
before laser-modifying the dielectric substrate (10), forming a structured sacrificial layer (14) on the first main surface (12A) of the dielectric substrate (10), wherein the structured sacrificial layer (14) is arranged between the etch stop layer (16) and the dielectric substrate (10) and is aligned with the region where the via hole (24) is to be etched, wherein the sacrificial layer (14) is removed during etching the via hole (24); and/or
forming a material layer on the structured sacrificial layer (14), wherein the etch stop layer (16) is formed on the material layer, wherein the material layer comprises at least one of TEOS, silicon nitride, aluminum oxide, silicon oxide, aluminum nitride.

4. The method of any of claims 1 to 3, wherein forming the etch stop layer (16) comprises:
arranging a silicon-on-insulator wafer (36) on the dielectric substrate (10), wherein the silicon-on-insulator wafer (36) comprises a degenerately doped crystalline silicon layer (38) facing the first main surface (12A) of the dielectric substrate (10), a buried oxide layer (40) arranged on the crystalline silicon layer (38) and a silicon layer (42) arranged on the buried oxide layer (40),
removing the silicon layer (42), thereby exposing the buried oxide layer (40), and
removing the buried oxide layer (40), thereby exposing the crystalline silicon layer (38).

5. The method of any of claims 1 to 4, further comprising:
forming a structured electrode layer (18C) over the metal layer (18A), wherein the structured electrode layer (18C) comprises multiple electrodes (32) of the ion trap configured to trap ions in a zone above the structured electrode layer (18C).

## Patentansprüche

1. Verfahren zur Herstellung einer elektrischen Durchkontaktierung durch ein dielektrisches Substrat (10) einer lonenfallenvorrichtung, wobei das Verfahren umfasst:
Ausbilden einer elektrisch leitenden Ätzstoppschicht (16) auf einer ersten Hauptoberfläche (12A) des dielektrischen Substrats (10);
Ausbilden mindestens einer Metallschicht (18A) einer Ionenfalle über der Ätzstoppschicht (16);
Ätzen eines Durchkontaktierungslochs (24) in eine zweite Hauptoberfläche (12B) des dielektrischen Substrats (10) gegenüber der ersten Hauptoberfläche (12A) und durch das dielektrische Substrat (10), so dass die Ätzstoppschicht (16) freiliegt; und
Anordnen eines elektrisch leitenden Materials (26) in dem Durchkontaktierungsloch (24), wobei die Ätzstoppschicht (16) das elektrisch leitende Material (26) und die Metallschicht (18A) elektrisch koppelt.

2. Verfahren nach Anspruch 1, wobei das Anordnen des elektrisch leitenden Materials (26) in dem Durchkontaktierungsloch (24) das Ausbilden einer elektrisch leitenden Schicht auf einer inneren Oberfläche des Durchkontaktierungslochs (24) und auf der freiliegenden Ätzstoppschicht (16) umfasst.

3. Verfahren nach Anspruch 1 oder 2, ferner umfassend:
vor dem Ätzen des Durchkontaktierungslochs (24), Lasermodifizieren des dielektrischen Substrats (10) in einem Bereich, wo das Durchkontaktierungsloch (24) geätzt werden soll, wodurch eine Ätzrate des dielektrischen Substrats (10) in dem lasermodifizierten Bereich erhöht wird; und/oder
vor dem Lasermodifizieren des dielektrischen Substrats (10), Ausbilden einer strukturierten Opferschicht (14) auf der ersten Hauptoberfläche (12A) des dielektrischen Substrats (10), wobei die strukturierte Opferschicht (14) zwischen der Ätzstoppschicht (16) und dem dielektrischen Substrat (10) angeordnet ist und mit dem Bereich, wo das Durchkontaktierungsloch (24) geätzt werden soll, ausgerichtet ist, wobei die Opferschicht (14) während des Ätzens des Durchkontaktierungslochs (24) entfernt wird; und/oder
Ausbilden einer Materialschicht auf der strukturierten Opferschicht (14), wobei die Ätzstoppschicht (16) auf der Materialschicht ausgebildet wird, wobei die Materialschicht mindestens eines von TEOS, Siliziumnitrid, Aluminiumoxid, Siliziumoxid, Aluminiumnitrid umfasst.

4. Verfahren nach einem der Ansprüche 1 bis 3, wobei das Ausbilden der Ätzstoppschicht (16) umfasst:
Anordnen eines Silizium-auf-Isolator-Wafers (36) auf dem dielektrischen Substrat (10), wobei der Silizium-auf-Isolator-Wafer (36) eine degenerierte dotierte kristalline Siliziumschicht (38), die der ersten Hauptoberfläche (12A) des dielektrischen Substrats (10) zugewandt ist, eine vergrabene Oxidschicht (40), die auf der kristallinen Siliziumschicht (38) angeordnet ist, und eine Siliziumschicht (42), die auf der vergrabenen Oxidschicht (40) angeordnet ist, umfasst,
Entfernen der Siliziumschicht (42), wodurch die vergrabene Oxidschicht (40) freigelegt wird, und
Entfernen der vergrabenen Oxidschicht (40), wodurch die kristalline Siliziumschicht (38) freigelegt wird.

5. Verfahren nach einem der Ansprüche 1 bis 4, ferner umfassend:
Ausbilden einer strukturierten Elektrodenschicht (18C) über der Metallschicht (18A), wobei die strukturierte Elektrodenschicht (18C) mehrere Elektroden (32) der Ionenfalle umfasst, die eingerichtet sind, Ionen in einer Zone über der strukturierten Elektrodenschicht (18C) einzufangen.

## Revendications

1. Un procédé de fabrication d'une connexion électrique par trou traversant un substrat (10) diélectrique d'un dispositif de piège à ions, le procédé comprenant :
former une couche (16) conductrice de l'électricité d'arrêt d'attaque chimique sur une première surface (12A) principale du substrat (10) diélectrique ;
former au moins une couche (18A) métallique d'un piège à ions sur la couche (16) d'arrêt d'attaque chimique ;
ménager par attaque chimique un trou (24) traversant dans une deuxième surface (12B) principale du substrat (10) diélectrique opposée à la première surface (12A) et dans le substrat (10) diélectrique, de manière à mettre à découvert la couche (16) d'arrêt d'attaque chimique ; et
mettre un matériau (26) conducteur de l'électricité dans le trou (24) traversant, dans lequel la couche (16) d'arrêt d'attaque chimique connecte le matériau (26) conducteur de l'électricité et la couche (18A) métallique.

2. Le procédé de la revendication 1, dans lequel mettre le matériau (26) conducteur de l'électricité dans le trou (24) traversant comprend former une couche conductrice de l'électricité sur une surface intérieure du trou (24) traversant et sur la couche (16) à découvert de l'arrêt d'attaque chimique.

3. Le procédé de la revendication 1 ou 2, comprenant en outre :
avant de ménager le trou (24) traversant par attaque chimique, modifier par laser le substrat (10) diélectrique dans une région où le trou (24) traversant doit être ménagé par attaque chimique, en augmentant ainsi une vitesse d'attaque du substrat (10) diélectrique dans la région modifiée par laser ; et/ou
avant de modifier par laser le substrat (10) diélectrique, former une couche (14) sacrificielle structurée sur la première surface (12A) principale du substrat (10) diélectrique, dans lequel la couche (14) sacrificielle structurée est disposée entre la couche (16) d'arrêt d'attaque chimique et le substrat (10) diélectrique et est alignée sur la région où le trou (24) traversant est à ménager par attaque chimique, dans lequel la couche (14) sacrificielle est éliminée pendant que l'on ménage le trou (24) traversant ; et/ou
former une couche de matériau sur la couche (14) sacrificielle structurée, dans lequel la couche (16) d'arrêt d'attaque chimique est formée sur la couche de matériau, dans lequel la couche de matériau comprend au moins l'un de TEOS, nitrure de silicium, oxyde d'aluminium, oxyde de silicium, nitrure d'aluminium.

4. Le procédé de l'une quelconque des revendications 1 à 3, dans lequel former la couche (16) d'arrêt d'attaque chimique comprend :
mettre une plaquette (36) silicium sur isolant sur le substrat (10) diélectrique, dans lequel la plaquette (36) silicium sur isolant comprend une couche (38) de silicium cristallin à dopage dégénéré faisant face à la première surface (12A) principale du substrat (10) diélectrique, une couche (40) d'oxyde enterrée disposée sur la couche (38) de silicium cristallin et une couche (42) de silicium disposée sur la couche (40) d'oxyde enterrée,
éliminer la couche (42) de silicium en mettant ainsi la couche (40) d'oxyde enterrée à découvert, et
éliminer la couche (40) d'oxyde enterrée en mettant ainsi la couche (38) de silicium cristallin à découvert.

5. Le procédé de l'une quelconque des revendications 1 à 4, comprenant en outre :
former une couche (18C) d'électrode structurée sur la couche (18A) métallique, dans lequel la couche (18C) d'électrode structurée comprend de multiples électrodes (32) du piège à ions configurées pour piéger des ions dans une zone au-dessus de la couche (18C) d'électrode structurée.
